# EUROPEAN PATENT SPECIFICATION

(11) **EP 1 391 542 B1**
(45) Date of publication and mention of the grant of the patent: **14.11.2007**
(21) Application number: 03014432.3
(22) Date of filing: 30.06.2003
(51) Int. Cl.: C30B 15/10, C30B 35/00

(54) **Reforming process of quartz glass crucible**
Reformierverfahren eines Quarzglastiegels
Procédé de reformage d'un creuset en verre de quartz

(30) Priority: 15.08.2002 JP 2002237039; 29.01.2003 JP 2003021196
(43) Date of publication of application: 25.02.2004
(73) Proprietor: Japan Super Quartz Corporation, Akita-city Akita 010-0065 (JP)
(72) Inventor: Fukui, Masanori, Japan Super Quartz Corporation, Akita-shi, Akita 010-0065 (JP); Satoh, Masaru, Japan Super Quartz Corporation, Akita-shi, Akita 010-0065 (JP)
(74) Representative: HOFFMANN EITLE

(56) References cited:
- EP-A- 1 002 770
- PATENT ABSTRACTS OF JAPAN vol. 1999, no. 13, 30 November 1999 (1999-11-30) & JP 11 236233 A (SUMIKIN SEKIEI KK), 31 August 1999 (1999-08-31)
- PATENT ABSTRACTS OF JAPAN vol. 2002, no. 04, 4 August 2002 (2002-08-04) & JP 2001 342029 A (MITSUBISHI MATERIAL QUARTZ KK), 11 December 2001 (2001-12-11)
- COCKAYNE B ET AL: "TECHNOLOGIES FOR REMOVING SILIDIFIED MELTS FROM PRECIOUS METAL CRUCIBLES SUBSEQUENT TO CZOCHRALSKI GROWTH" JOURNAL OF CRYSTAL GROWTH, NORTH-HOLLAND PUBLISHING CO. AMSTERDAM, NL, vol. 142, no. 3/4, 2 September 1994 (1994-09-02), pages 357-361, XP000468431 ISSN: 0022-0248

## Description

### BACKGROUND OF THE INVENTION

### [TECHNICAL FIELD OF THE INVENTION]

The present invention relates to a reforming process of a quartz glass crucible for pulling up single crystal silicon by a ring-like arc discharge, which is suitable to reform the crucible having a large open diameter especially.

### [DISCUSSION OF THE BACKGROUND]

When the single crystal silicon is pulled up from fused silicon, the quartz glass crucible has been used as the vessel to take in said fused silicon. Conventionally, said crucible is produced by fusing a quartz powder by an arc flame. However, there are problems that silicon oxide etc. (SiO₂, SiO, etc.) being evaporated during the fusing is condensed again to fall down to the inside surface of the crucible and to form a foreign substance, or a metal powder being an impurity or a substance other than silica is adhered and included to the inside surface of the crucible to form the foreign substance. Moreover, a bubble being included at near the inside surface of the crucible is often expanded to burst to form an irregularity on the inside surface. When said foreign substance or irregularity is existed at the inside surface of the quartz glass crucible, or the bubble is existed under said inside surface, a reforming treatment, in which the inside surface is refused to remove the foreign substance or the bubble, has been carried out. Conventionally, at the said reforming treatment, the arc discharge being used for the production of the crucible is used as the means for heating the inside surface of the crucible.

### [Problems to be solved]

The conventional electrode structure forming the arc discharge is the structure having 3 electrodes to 3 phases alternating current in general, in which 3 electrodes are used, and the 3 phases alternating electric current flows to said 3 electrodes to form the arc (discharge) plasma between each of the electrodes. However, said structure has a fault that the arc becomes unstable to be cut off when a distance between the electrodes is increased in order to expand the heating range. Especially, as for the large size crucible, the influence of air stream at the inside of the crucible by the rotation of the mould becomes large, so that the arc is cut off easily in the conventional electrode structure. Such electrode configuration is e.g. known from JP-A-11-236233.

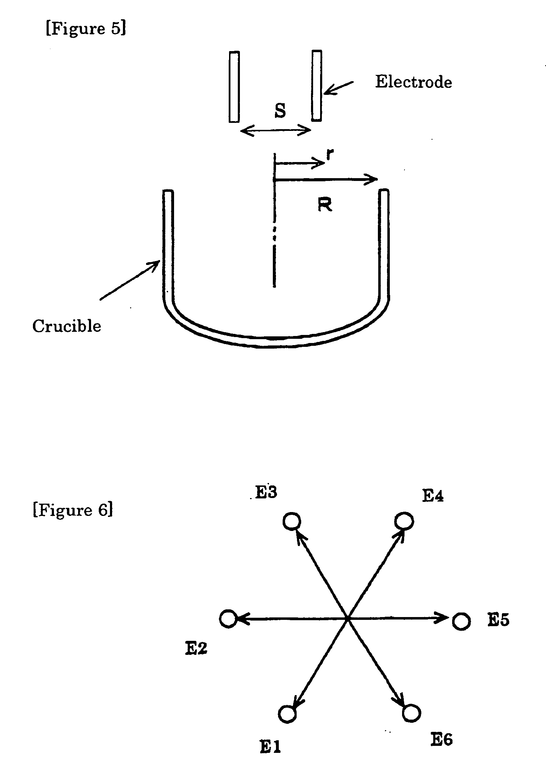

Therefore, trials increasing the number of the electrode to expand the heating range have been carried out, and the structure having 6 electrodes to 6 phases alternating current is proposed. However, as for the structure having 6 electrodes to 6 phases current, as shown in Figure 6, it is easy to generate the arc discharge between the electrodes facing each other rather than between the electrodes neighboring each other, so that there is a problem that the heat of discharge at the central portion being encircled with the electrodes becomes large excessively rather than the heat at the around portion, so that it is difficult to heat uniformly the inside of the crucible.

Moreover, although the arc can be inclined in order to heat the wall portion, the arc becomes unstable easily and the device becomes complicated in the conventional electrode structure. In addition, although an oxyhydrogen flame or a plasma flame is suitable for a partial heating, the reformed face becomes un-uniform easily because of the partial heating, and the treatment time is also long. Moreover, when the partial heating is carried out, it is necessary to carry out an annealing, and if the annealing is not carried out, there is a problem that the crucible is broken at the time of the cooling down. Furthermore, as for the heating by the oxyhydrogen flame, a concentration of an OH group at the heating portion becomes high, so it is not preferable.

### SUMMARY OF THE INVENTION

The present invention solves said problems of the conventional electrode structure in the production device of a quartz glass crucible. In addition, the present invention provides a reforming process of a quartz glass crucible according to the electrode structure forming a ring-like arc, which is stable and has a large heating range, and is suitable for the production of a crucible having a large open diameter.

That is, the present invention relates to the following reforming process of the quartz glass crucible.

The reforming process of the invention is defined in claims 1, 2 or 3. Embodiments of the invention are defined in the dependent claims.

According to the reforming process of the present invention, although the ring-like arc discharge being generated between the electrodes neighboring each other at both sides is formed, the stable arc discharge is not formed substantially between the electrodes facing each other across the central portion of the ring. Therefore, the central portion being encircled with the electrodes is not heated excessively, and it is possible to heat uniformly the inside of the crucible. Moreover, in order to expand the heating range, only the distance between the electrodes neighboring each other can be increased within the range, in which the arc discharge is possible, so that it is possible to heat uniformly the crucible having a large open diameter, and to obtain the excellent reformed crucible, in which the whole inside surface of the crucible is refused uniformly.

The above-described production process of the present invention may include the following production processes.

A reforming process of the quartz glass crucible, the process comprising,
using the electrode structure, in which the electrodes neighboring each other are positioned at regular interval in the ring configuration so as to have an absolute value θ of a phase difference of alternating electric current in the range of 90° ≤ θ ≤ 180° and,
forming the ring-like arc.

A reforming process of the quartz glass crucible, the process comprising,
using the electrode structure, in which the electrodes neighboring each other are positioned at regular interval in the ring configuration, and
forming the ring-like arc,
wherein the radius r of the circumference of the ring at around of the rotational axis of the mould is from 1 to 1/4 to the radius R of an open of the crucible for at least a fixed time during an arc heating.

In addition, the above-described production process of the present invention may also include the following production processes.

A reforming process of a quartz glass crucible, the process comprising,
removing mechanically the foreign substance on the inside surface of the crucible or the bubble just under said inside surface by grinding,
forming the above-described ring-like arc discharge and fusing the inside surface of the crucible to be smoothed.

A reforming process of a quartz glass crucible, the process comprising,
reforming the quartz glass crucible having the diameter of the crucible of from 68.6 cm to 98 cm (28 to 40 inches).

A reforming process of a quartz glass crucible, the process comprising,
reforming the quartz glass crucible being used for pulling up single crystal silicon.

According to the reforming process of the present invention, the inside surface of the crucible can be heated by forming the ring-like arc along with said inside surface without forming the arc crossing the central portion substantially, so that the central portion is not heated excessively, and it is possible to heat uniformly. Moreover, when the size of the ring being formed with plural electrodes is within the above-described range, the suitable heating distance can be kept to the open diameter of the quartz glass crucible, and the side wall portion, the corner portion, and the bottom portion of the crucible can be heated uniformly. Therefore, as for the large size quartz glass crucible having the diameter of the crucible of from 68.6 cm to 98 cm (28 to 40 inches), it is possible to obtain the excellent reformed crucible having the uniform refused face. In addition, said reforming process includes not only the process, in which the foreign substance or the bubble at the inside surface of the crucible can be removed directly by heating to be fused, but also the process, in which the inside surface of the crucible can be smoothed by forming the above-described ring-like arc discharge to fuse said inside surface after removing mechanically the foreign substance or the bubble at said inside surface by grinding.

### BRIEF DESCRIPTION OF THE DRAWINGS

[Figure 1] : Conceptual figure showing the electrode structure having the 6 electrodes of the 3 phases alternating current being used in the present invention.

[Figure 2]: Conceptual figure showing the electrode structure having the 9 electrodes of the 3 phases alternating current being used in the present invention.

[Figure 3] Conceptual figure showing the electrode structure having the 4 electrodes of the 2 phases alternating current being used in the present invention.

[Figure 4]: Conceptual figure showing the electrode structure having the 8 electrodes of the 4 phases alternating current being used in the present invention.

[Figure 5] : Figure showing the relation of the circumference diameter being positioned with the electrodes and the open diameter of the crucible.

[Figure 6] : Conceptual figure showing the conventional electrode structure.

### [DESCRIPTION OF THE CORDS]

E1 to E9 are Electrodes
r is the radius of the circumference being positioned with the electrodes
R is the radius of the open diameter of the crucible
S is the circumference of the ring

### DETAILED DESCRIPTION OF THE PREFERRED EMBODIMENT

Hereinafter, the present invention will be described concretely with the preferred embodiment. In addition, in the following explanation, the word of "foreign substance" may also include the irregularity of the inside surface of the crucible.

The present invention relates to the reforming process of the quartz glass crucible, in which the quartz glass crucible is reformed by the way that an arc discharge is generated by electrodes being positioned at around of a rotational axis to heat an inside surface of the crucible to be fused while rotating said quartz glass crucible. The process is characterized by using an electrode structure, in which the electrodes neighboring each other are positioned at regular interval in a ring configuration, forming a stable ring-like arc being generated between the electrodes neighboring each other without generating a continuous arc between electrodes facing each other across the central portion of the ring, heating the inside surface of the crucible to be fused, and removing the foreign substance on said inside surface or the bubble under said inside surface.

The reforming process of the present invention comprises the electrode structure, in which the electrodes neighboring each other are positioned at regular interval in the ring configuration at around of the rotational axis of the mould, in order to heat uniformly the inside surface of the mould to be fused without heating excessively the bottom portion of the quartz crucible. In said electrode structure, the stable ring-like arc being generated between the electrodes neighboring each other is formed without forming the continuous arc between the electrodes facing each other across the central portion of the ring, and for example, the phase difference θ (the absolute value) of the alternating electric currents between the electrodes neighboring each other becomes in the range of 90° ≤ θ ≤ 180°. In addition, in the following explanations, the phase difference θ between the electrodes neighboring each other is the absolute value. As such electrode structure, the electrode structure having 4 electrodes to 2 phases alternating current, 6 electrodes to 3 phases alternating current, 9 electrodes to 3 phases alternating current or 8 electrodes to 4 phases alternating current can be used. When the each electrode is connected with a direct current, it is preferable that even electrodes are positioned in the ring configuration so as to become the electrodes neighboring each other having the different phases respectively.

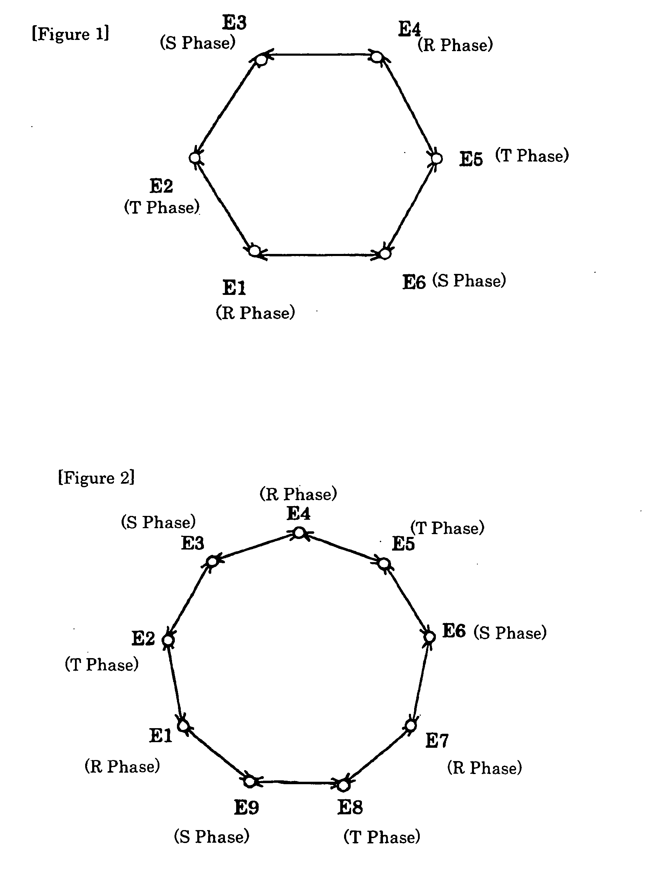

An example of the electrode structure being used in the present invention is shown in Figure 1. In the example shown in Figure 1, the 6 electrodes (E1 to E6) are used to the 3 phases alternating electric current. In this electrode structure, the electrodes neighboring each other are positioned at regular interval at around of the rotational axis of the crucible to form the hexagonal ring connecting each electrode. To the 3 phases alternating electric current, the phase difference between the electrodes neighboring each other is 120° , and the electrodes facing each other across the central portion of the ring have the same phases each other. More particularly, the each electrode is connected as follows. That is, the electrode E4 facing to the electrode E1 across the central portion of the ring has the same R phase when the electrode E1 has the R phase to the 3 phases alternating electric current, and at this time, the electrodes E2 and E6, which are both side of the electrode E1, have the T phase and the S phase respectively, and the electrodes E3 and E5, which are the outer side of the electrodes E2 and E6, have the S phase and the T phase respectively. Therefore, the electrodes E1 and E4, the electrodes E2 and E5, and the electrodes E3 and E6 have the same phases respectively, and have the different phases to the other electrodes respectively.

In the electrode structure shown in Figure 1, since the electrodes E2 and E6, which are both side of the electrode E1, have the different phases to the electrode E1, the stable arc can be formed between the electrode and the both side ones. Therefore, the rig-like arc being generated between the electrodes neighboring each other can be formed along with the inside surface of the crucible. On the other hand, since the electrodes E1 and E4, which are facing each other across the central portion of the ring, have the same phases, the arc crossing at the central portion of the ring cannot be formed, so that the central portion of the crucible cannot be heated excessively. Moreover, in the above-described electrode structure, when the distance between the electrodes neighboring each other is increased in order to expand the heating range, the arc is formed by generating between the electrode and the closing ones, which are the nearest one, so that it is difficult to cut off the arc and is possible to keep the stable arc. In addition, in the present invention, the ring-like arc along with the inside surface of the crucible includes not only the arc being formed with the electrodes sticking out to the inside of the crucible but also the arc being formed in a concentric circle to the inner peripheral face of the crucible by the electrodes being positioned at the upper of the open of the crucible.

The example using the 9 electrodes (E1 to E9) to the 3 phases alternating electric current is shown in Figure 2. In this electrode structure, the electrodes neighboring each other are positioned at around of the rotational axis so as to have the regular interval each other, and a nonagon ring connecting each electrode is formed. The phase difference between the electrodes neighboring each other is 120° to the 3 phases alternating electric current. More particularly, as shown in Figure 2, when the electrode E1 has the R phase, the electrodes E2 and E9, which are both side of the electrode E1, have the T phase and the S phase respectively, the electrodes E3 and E5, which are both side of the electrode E4, have the S phase and the T phase respectively, and the electrodes E6 and E8, which are both side of the electrode E7, have the S phase and the T phase respectively. At this time, since the electrodes E2 and E9, which are closing to the electrode E1, have the phase difference to the electrode E1, the stable arc can be formed between the electrode E1 and the electrodes E2 and E9. However, since the electrodes E4 and E7, which are facing to the electrode E1 across the central portion of the ring-like arc, have the same phases as the electrode E1, the arc cannot be formed between these electrodes. In addition, the electrodes E3 and E8, which are next closing to the electrode E1, and the electrodes E5 and E6, which are facing to the electrode E1 across the central portion of the ring-like arc, have the phase difference to the electrode E1. However, since the distances between the electrode E1 and these electrodes E3, E8, E5, and E6 are larger than the distance from the electrodes E2 and E9, if the arc is generated temporarily between these electrodes and the electrode E1, the arc cannot be kept and the stable arc cannot be formed. Therefore, the arc crossing the central portion being encircled with the electrodes cannot be formed substantially, and the ring-like arc being generated between the electrodes neighboring each other can be formed. Commonly, in the electrode structure having 3n electrodes to 3 phases alternating current (n≥ 4), the ring-like arc being generated between the electrodes neighboring each other is formed like the above-description, and the stable arc crossing the central portion of the ring is not formed substantially.

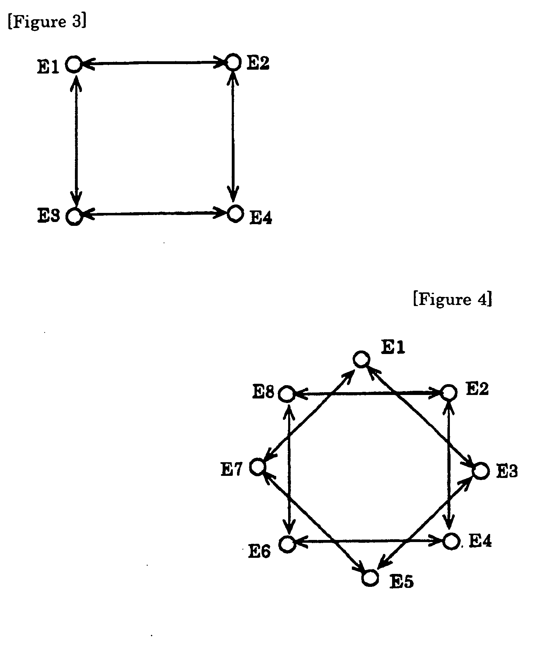

The example using the 4 electrodes (E1 to E4) to the 2 phases alternating electric current is shown in Figure 3. In this electrode structure, the electrodes neighboring each other are positioned at regular interval at around of the rotational axis of the mould to form the square ring connecting each electrode. Since the phase difference between the electrodes neighboring each other is 180° to the 2 phases alternating electric current, the arc is generated between the electrodes neighboring each other. However, since the electrodes facing each other across the central portion of the ring have the same phases each other, the arc is not generated between these electrodes, and the arc crossing the central portion of the ring cannot be formed. Commonly, in the electrode structure having 2n electrodes to 2 phases alternating current (n ≥ 3), the ring-like arc being generated between the electrodes neighboring each other is formed like the above-description, and the stable arc crossing at the central portion of the ring is not formed substantially.

The example using the 8 electrodes (E1 to E8) to the 4 phases alternating electric current is shown in Figure 4. In this electrode structure, the electrodes neighboring each other are positioned at regular interval at around of the rotational axis of the mould to form the octagonal ring connecting each electrode. To the 4 phases alternating electric current, the phase difference between the electrodes neighboring each other is 90° , and the phase difference between the electrodes, which are next closing to each other, is 180° . Since the arc is generated mainly between the electrodes having the large phase difference, the arc is generated between the electrodes, which are next closing to each other, in this structure. So, the ring-like arc can be formed between the electrodes, which are next closing to each other. In the present invention, the ring-like arc being generated between the electrodes neighboring each other includes the ring-like arc being generated between the electrodes, which are next closing to each other. On the other hand, since the electrodes facing each other across the central portion of the ring have the same phases each other, the arc is not formed between these electrodes. Moreover, if the arc is generated temporarily between the facing electrodes having the phase difference across the central portion of the ring, the distance between the electrodes is large, so that the arc is not kept. So, the stable arc cannot be formed substantially.

By the way, in the conventional structure having the 6 electrodes to the 6 phases alternating current, which is shown in Figure 6, the phases of the electric current of from the electrode E2 to E6 have been shifted to the electrode E1 by a unit of 60° , and the phase difference between the electrode E1 and the electrode E4 being positioned at the opposite side of the electrode E1 becomes the largest value, i.e. 180° . It is easy to generate the arc between the electrodes having the largest phase difference of the electric currents. So, in the conventional electrode structure, the arc is generated between the electrodes E1 and E4, E2 and E5, and E3 and E6, which are positioned by facing each other (at the diagonal line position), and are crossed at the central portion being encircled with from the electrode E2 to the electrode E6. Furthermore, in the conventional electrode structure, when the distance between the electrodes neighboring each other is increased, the distance between the electrodes facing each other becomes to be increased sharply, so the arc becomes unstable to be cut off easily. On the other hand, in the electrode structure of the present invention, since the ring-like arc being generated between the electrodes neighboring each other can be formed, when the distance between the electrodes is increased, it is difficult to cut off the arc and is possible to keep the stable arc.

Next, as shown in Figure 5, as for the size of the ring being formed by connecting the electrodes (E1 to E6), it is preferable that the radius r of the circumference S, which is the circumference of the ring at around of the rotational axis, is from 1 to 1/4 to the radius R of the open of the crucible, at least for a fixed time at the time of arc heating. In this range, heating can be uniform from the sidewall portion to the corner portion and the bottom portion of the crucible. On the other hand, if the radius r of the circumference S, in which the electrodes are positioned, is larger than the radius R of the open of the crucible, the electrode can not be inserted into the inside of the crucible, so that the bottom portion of the crucible can not be heated sufficiently. Moreover, if the radius r of the circumference is smaller than 1/4 of the radius R of the open of the crucible, the side wall portion of the crucible can not be heated sufficiently.

In the reforming process of the present invention, in which the electrode structure having the 6 electrodes to the 3 phases alternating current is used, when the arc heating is carried out from the upper side of the mould, the above-described effect is remarkable especially. At the time of the arc fusion, a big air stream is aroused at around of the crucible by an exhaust gas of a furnace or convection at the inside of the crucible. When the arc heating is carried out from the upper side of the mould, there are greatly influenced of said air stream. So, the arc is cut off immediately with the 3 electrodes when the distance between the electrodes is increased. On the other hand, as for the structure having the 6 electrodes to the 3 phases alternating current, when the arc heating is carried out from the upper side of the mould, it is possible to obtain the stable arc. Therefore, as for the large size quartz glass crucible having the diameter of the crucible of from 28 to 40 inches, it is possible to obtain the excellent reformed crucible having the uniform refused face.

In the reforming process of the present invention, the heating temperature by the arc discharge is in the temperature range, in which the inside surface of the crucible can be refused without deforming said crucible. In addition, according to the necessity, the air is passed on an outer face of the crucible at the time of the arc heating to carry out an air cool. By said air-cooling, it is possible to prevent the deformation of the crucible much more certainly.

Moreover, the above-described reforming process of the present invention includes not only the process, in which the foreign substance or the bubble at the inside surface of the crucible can be removed directly by fusing, but also the process, in which the foreign substance or the bubble at said inside surface can be removed mechanically by grinding, and then the inside surface of the crucible can be fused by forming the above-described ring-like arc discharge to be smoothed. For example, when the foreign substance, such as silica or the metal powder being the impurity, adheres on the inside surface of the crucible, if said foreign substance is present in a depth of about less than 0.2 mm from the inside surface of the crucible, it is possible to remove the foreign substance by the above-described arc fusion without carrying out the mechanical grinding. If the foreign substance is present in a depth of about more than 0.2 mm from the inside surface. it is preferable that the inside surface of the crucible is smoothed by the above-described arc fusion after carrying out the mechanical grinding.

### EXAMPLES

Hereinafter, the present invention is explained with Examples.

### [Example 1]

As for the quartz glass crucible having the diameter of the crucible of 32 inches, the treatment for removing the bubble just under the inside surface was carried out, using the heating devices having the 6 electrodes to the 3 phase alternating current, in which the radius r of the ring being formed with the electrodes could be expanded to more than 1/4 to the radius R of the crucible, the conventional 3 electrodes to the 3 phases alternating current, and 6 electrodes to the 3 phases alternating current, wherein electric power was given for 10 minutes. Moreover, a test of pulling up the single crystal silicon was carried out. These results were shown in Table 1.

As for the reforming treatment of the present invention, in which the heating device having the 6 electrodes to the 3 phases alternating current was used, since the distance between the electrodes could be increased like the above-description, it was possible to reduce the bubbles at the bottom portion and the wall portion of the crucible. On the other hand, as for Comparison samples, in which the electrode structures having the 3 electrodes to the 3 phases alternating current and the 6 electrodes to the 6 phases alternating current were used, it was possible to remove the bubble at the bottom portion of the crucible. However, when the radius r was expanded to more than 1/4 to the radius R of the crucible, the arc was cut off or became unstable, so that it was impossible to remove the bubble at the sidewall portion of the crucible.

**[Table 1]**

| | Diameter of Circumference | Bubble Content before Reforming Treatment | | Bubble Content after Reforming Treatment | | Dislocation Free Ratio of Single Crystal | Evaluation |
|---|---|---|---|---|---|---|---|
| | | Wall Portion | Bottom Portion | Wall Portion | Bottom Portion | | |
| Example 1 | Change in the range of from 100 to 500 mm | 0.50% | 0.30% | 0.03% | 0.01% | 80% | ⊚ |
| 6 electrodes to 3 phases alternating current | | | | | | | |
| Comparison Example 1 | 50 mm | 0.50% | 0.30% | 0.50% | 0.01% | 20% | × |
| 3 electrodes to 3 phases alternating current | | | | | | | |
| Comparison Example 2 | 150 mm | 0.50% | 0.30% | 0.40% | 0.01% | 30% | × |
| Non-reformed Product | | | | | | | |

### [Example 2]

As for the quartz glass crucible having the diameter of the crucible of 32 inches, the treatment for removing the foreign substance was carried out, using the heating devices having the 6 electrodes to the 3 phases alternating current being shown in the Figure 1 and the conventional 3 electrodes to the 3 phases alternating current (Comparison Example 1), wherein the electric power was given for 10 minutes. Moreover, a test of pulling up the single crystal silicon was carried out. These results were shown in Table 2. In addition, the result of the non-reformed product was shown as the Comparison Example 2.

As for Example, in which the reforming treatment of the present invention was carried out, the foreign substances at the wall portion and the bottom portion of the crucible was removed completely, and the dislocation free ratio of the single crystal at the time of using the reformed crucible was 80%, which was high dislocation free ratio. On the other hand, as for Comparison Example 1, in which the 3 phases alternating current flowed to the conventional 3 electrodes, the contamination part at the wall portion was hardly removed, and the dislocation free ratio of the single crystal was 45%, which was low. In addition, in the case of the reforming treatment of Comparison Example 1, when the amount of the flowing current was set to two times in order to increase the treatment effect, the crucible was deformed, so that said crucible could not be used for pulling up the single crystal, and as a result, it was impossible to remove the foreign substance or the bubble at the wall portion.

**[Table 2]**

| | Number of Foreign substance before Reforming Treatment | | Number of Foreign substance after Reforming Treatment | | Dislocation Free Ratio of Single Crystal | Evaluation |
|---|---|---|---|---|---|---|
| | Wall Portion | Bottom Portion | Wall Portion | Bottom Portion | | |
| Example 2 | 24 | 17 | 0 | 0 | 80% | ⊚ |
| 6 electrodes to 3 phases alternating current | | | | | | |
| Comparison Example 2-1 | 24 | 17 | 22 | 0 | 45% | × |
| 3 electrodes to 3 phases alternating current | | | | | | |
| Comparison Example 2-2 | 24 | 17 | - | - | 30% | × |
| Non-reformed Product | | | | | | |

| | | | | | | |
|---|---|---|---|---|---|---|
| [Note] As for Comparison Example 1, when the amount of the flowing current was set to two times. the crucible was deformed. As for Evaluation. ⊚ is sufficient, and × is insufficient. | | | | | | |

### EFFECTIVENESS OF THE INVENTION

According to the reforming process of the present invention, the arc is stable and the heating range is large. In addition, it is possible to heat uniformly from the sidewall portion to the bottom portion without heating the bottom portion excessively. Therefore, it is possible to refuse the inside surface of the crucible to remove the foreign substance or the bubble at said inside surface, and to form the uniform refused face at the whole inside surface also about the large size crucible, so that it is possible to obtain the excellent reformed crucible.

## Claims

1. A reforming process of a quartz glass crucible, wherein the quartz glass crucible is reformed by the way that an arc discharge is generated by electrodes being positioned at around of a rotational axis to heat an inside surface of the crucible to be fused while rotating said quartz glass crucible, the process comprising,
using an electrode structure having 3n electrodes to 3 phases, n being equal to or larger than 2, wherein the electrodes neighboring each other are positioned at regular intervals in a ring configuration, so as to form a stable ring-like arc being generated between the electrodes neighboring each other without generating a continuous arc between electrodes facing each other across the central portion of the ring,
heating the inside surface of the crucible to be fused, and
removing a foreign substance on said inside surface or a bubble under said inside surface.

2. A reforming process of a quartz glass crucible, wherein the quartz glass crucible is reformed by the way that an arc discharge is generated by electrodes being positioned at around of a rotational axis to heat an inside surface of the crucible to be fused while rotating said quartz glass crucible, the process comprising,
using an electrode structure having 2n electrodes to 2 phases, n being equal to or larger than 2, wherein the electrodes neighboring each other are positioned at regular intervals in a ring configuration, so as to form a stable ring-like arc being generated between the electrodes neighboring each other without generating a continuous arc between electrodes facing each other across the central portion of the ring,
heating the inside surface of the crucible to be fused, and
removing a foreign substance on said inside surface or a bubble under said inside surface.

3. A reforming process of a quartz glass crucible, wherein the quartz glass crucible is reformed by the way that an arc discharge is generated by electrodes being positioned at around of a rotational axis to heat an inside surface of the crucible to be fused while rotating said quartz glass crucible, the process comprising,
using an electrode structure having 8 electrodes to 4 phases, wherein the electrodes neighboring each other are positioned at regular intervals in a ring configuration, so as to form a stable ring-like arc being generated between the electrodes neighboring each other without generating a continuous arc between electrodes facing each other across the central portion of the ring,
heating the inside surface of the crucible to be fused, and
removing a foreign substance on said inside surface or a bubble under said inside surface.

4. The reforming process of the quartz glass crucible according to any one of claims 1 to 3, wherein
the electrodes neighboring each other are positioned at regular intervals in the ring configuration so as to have an absolute value θ of a phase difference of alternating electric current in the range of 90 ≤ θ ≤180.

5. The reforming process of the quartz glass crucible according to any one of the preceding claims, wherein
the radius r of the circumference of the ring at around of the rotational axis of the mould is from 1 to 1/4 to the radius R of an opening of the crucible for at least a fixed time during an arc heating.

6. A reforming process of a quartz glass crucible according to any one of the preceding claims, wherein
the foreign substance on the inside surface of the crucible or the bubble just under the inside surface of the crucible is mechanically reduced by grinding, and wherein the process further comprises
fusing the inside surface of the crucible to be smoothed.

7. The reforming process of a quartz glass crucible according to any one of the preceding claims, the process comprising,
reforming the quartz glass crucible having the diameter of the crucible of from 68.6 cm to 98 cm (28 to 40 inches).

8. The reforming process of a quartz glass crucible according to any one of Claims 1 to 6, the process comprising,
reforming the quartz glass crucible being used for pulling up single crystal silicon.

## Patentansprüche

1. Reformverfahren für einen Quarzglastiegel, wobei der Quarzglastiegel dadurch reformiert wird, dass eine Bogenentladung durch Elektroden erzeugt wird, die um die Drehachse herum positioniert sind, um eine aufzuschmelzende Innenoberfläche des Tiegels zu erhitzen, während der Quarzglastiegel gedreht wird, wobei das Verfahren umfasst:
die Verwendung eines Elektrodenaufbaus mit 3n Elektroden bei drei Phasen, wobei n gleich oder größer 2 ist, wobei diejenigen Elektroden, die einander benachbart sind, in regelmäßigen Intervallen in einem Ringaufbau positioniert sind, so dass ein stabiler ringförmiger Bogen zwischen den zueinander benachbarten Elektroden ohne Erzeugung eines kontinuierlichen Bogens zwischen Elektroden, die einander über den zentralen Abschnitt des Rings hinweg gegenüberstehen, erzeugt wird,
Erhitzung der aufzuschmelzenden Innenoberfläche des Tiegels, und
Entfernung von Fremdsubstanzen von dieser Innenoberfläche oder einer Blase unterhalb dieser Innenoberfläche.

2. Reformverfahren für einen Quarzglastiegel, wobei der Quarzglastiegel dadurch reformiert wird, dass eine Bogenentladung mittels Elektroden erzeugt wird, die um eine Drehachse positioniert sind, um eine aufzuschmelzende Innenoberfläche des Tiegels zu erhitzen, während der Quarzglastiegel gedreht wird, wobei das Verfahren umfasst:
die Verwendung eines Elektrodenaufbaus mit 2n Elektroden bei zwei Phasen, wobei n gleich oder größer 2 ist und wobei diejenigen Elektroden, die zueinander benachbart sind, in gleichmäßigen Intervallen in einem Ringaufbau positioniert sind, um so einen stabilen ringähnlichen Bogen auszubilden, der zwischen den Elektroden, die zueinander benachbart sind, erzeugt werden, ohne dabei einen kontinuierlichen Bogen zwischen solchen Elektroden zu erzeugen, die einander über den zentralen Abschnitt des Tiegels hinweg gegenüberstehen,
Erhitzung der aufzuschmelzenden Innenoberfläche des Tiegels, und
Entfernung einer Fremdsubstanz von der Innenoberfläche oder einer Blase unterhalb dieser Innenoberfläche.

3. Reformverfahren für einen Quarzglastiegel, wobei der Quarzglastiegel dadurch reformiert wird, dass eine Bogenentladung durch Elektroden erzeugt wird, die um eine Drehachse herum positioniert sind, um eine aufzuschmelzende Innenoberfläche des Tiegels zu erhitzen, während der Glastiegel gedreht wird, wobei das Verfahren umfasst:
die Verwendung eines Elektrodenaufbaus mit acht Elektroden bei vier Phasen, wobei die zueinander benachbart stehenden Elektroden in gleichmäßigen Intervallen in einem Ringaufbau positioniert sind, um so einen stabilen, ringähnlichen Bogen auszubilden, der zwischen denjenigen Elektroden erzeugt wird, die zueinander benachbart sind, ohne dabei einen kontinuierlichen Bogen zwischen solchen Elektroden zu erzeugen, die einander über den zentralen Abschnitt des Rings hinweg gegenüberstehen,
Erhitzung der aufzuschmelzenden Innenoberfläche des Tiegels, und.
Entfernung einer Fremdsubstanz von der Innenoberfläche oder einer Blase unterhalb der Innenoberfläche.

4. Reformverfahren für einen Quarzglastiegel gemäß einem der Ansprüche 1 bis 3, wobei
die zueinander benachbart stehenden Elektroden in gleichmäßigen Intervallen in einem Ringaufbau so positioniert sind, dass sie einen absoluten Wert θ einer Phasendifferenz eines Wechselstroms im Bereich von 90 ≤ θ ≤ 180 aufweisen.

5. Reformverfahren für einen Quarzglastiegel gemäß einem der voranstehenden Ansprüche, wobei
der Radius r des Umfangs des Rings um die Drehachse der Gussform zwischen 1 bis ¼ des Radius R einer Öffnung des Tiegels für zumindest eine feststehende Zeit während einer Bogenerhitzung ist.

6. Reformverfahren für einen Quarzglastiegel gemäß einem der voranstehenden Ansprüche, wobei
die Fremdsubstanz auf der Innenoberfläche des Tiegels oder die Blase direkt unterhalb der Innenoberfläche des Tiegels mechanisch durch Schleifen reduziert wird und wobei das Verfahren des Weiteren das Aufschmelzen der einzuebnenden Innenoberfläche des Tiegels umfasst.

7. Reformverfahren für einen Quarzglastiegel gemäß einem der voranstehenden Ansprüche, wobei das Verfahren umfasst:
die Reformierung des Quarzglastiegels mit einem Durchmesser des Tiegels von 68,6 cm bis 98 cm (28 bis 40 Inch).

8. Reformverfahren für einen Quarzglastiegel gemäß einem der Ansprüche 1 bis 6, wobei das Verfahren umfasst:
die Reformierung des Quarzglastiegels, der zum Aufziehen eines Silicium-Einkristals verwendet wurde.

## Revendications

1. Procédé de reformage d'un creuset en verre de quartz, dans lequel le creuset en verre de quartz est reformé par le fait qu'une décharge d'arc est générée par des électrodes placées autour d'un axe de rotation pour chauffer une surface intérieure du creuset devant être fondue tout en faisant tourner ledit creuset en verre de quartz, le procédé comprenant les étapes consistant à
utiliser une structure d'électrodes comportant 3n électrodes à 3 phases, n étant supérieur ou égal à 2, dans lequel les électrodes voisines les unes des autres sont placées à intervalles réguliers en une configuration d'anneau, de sorte à former un arc stable en forme d'anneau généré entre les électrodes voisines les unes des autres sans générer d'arc continu entre les électrodes situées en face les unes des autres à travers la partie centrale de l'anneau,
chauffer la surface intérieure du creuset devant être fondue, et
éliminer une substance étrangère sur ladite surface intérieure ou une bulle sous ladite surface intérieure.

2. Procédé de reformage d'un creuset en verre de quartz, dans lequel le creuset en verre de quartz est reformé par le fait qu'une décharge d'arc est générée par des électrodes placées autour d'un axe de rotation pour chauffer une surface intérieure du creuset devant être fondue tout en faisant tourner ledit creuset en verre de quartz, le procédé comprenant les étapes consistant à
utiliser une structure d'électrodes comportant 2n électrodes à 2 phases, n étant supérieur ou égal à 2, dans lequel les électrodes voisines les unes des autres sont placées à intervalles réguliers en une configuration d'anneau, de sorte à former un arc stable en forme d'anneau généré entre les électrodes voisines les unes des autres sans générer d'arc continu entre les électrodes situées en face les unes des autres à travers la partie centrale de l'anneau,
chauffer la surface intérieure du creuset devant être fondue, et
éliminer une substance étrangère sur ladite surface intérieure ou une bulle sous ladite surface intérieure.

3. Procédé de reformage d'un creuset en verre de quartz, dans lequel le creuset en verre de quartz est reformé par le fait qu'une décharge d'arc est générée par des électrodes placées en un endroit autour d'un axe de rotation pour chauffer une surface intérieure du creuset devant être fondue tout en faisant tourner ledit creuset en verre de quartz, le procédé comprenant les étapes consistant à
utiliser une structure d'électrodes ayant 8 électrodes à 4 phases, dans lequel les électrodes voisines les unes des autres sont placées à intervalles réguliers en une configuration d'anneau, de sorte à former un arc stable en forme d'anneau généré entre les électrodes voisines les unes des autres sans générer d'arc continu entre les électrodes situées en face les unes des autres à travers la partie centrale de l'anneau,
chauffer la surface intérieure du creuset devant être fondue, et
éliminer une substance étrangère sur ladite surface intérieure ou une bulle sous ladite surface intérieure.

4. Procédé de reformage d'un creuset en verre de quartz selon l'une quelconque des revendications 1 à 3, dans lequel
les électrodes voisines les unes des autres sont placées à intervalles réguliers en la configuration d'anneau de sorte à avoir une valeur absolue θ d'une différence de phase de courant électrique alternatif dans la plage 90 ≤ θ ≤ 180.

5. Procédé de reformage d'un creuset en verre de quartz selon l'une quelconque des revendications précédentes, dans lequel
le rayon r de la circonférence de l'anneau autour de l'axe de rotation du moule représente de 1 fois à 1/4 fois le rayon R d'une ouverture du creuset pendant au moins une durée fixe au cours d'un chauffage à l'arc.

6. Procédé de reformage d'un creuset en verre de quartz selon l'une quelconque des revendications précédentes, dans lequel
la substance étrangère sur la surface intérieure du creuset ou la bulle juste sous la surface intérieure du creuset est réduite mécaniquement par rectification, et dans lequel le procédé comprend en outre l'étape consistant à
fondre la surface intérieure du creuset devant être lissée.

7. Procédé de reformage d'un creuset en verre de quartz selon l'une quelconque des revendications précédentes, le procédé comprenant l'étape consistant à
reformer le creuset en verre de quartz ayant le diamètre de creuset dans la plage de 68,6 cm à 98 cm (28 pouces à 40 pouces).

8. Procédé de reformage d'un creuset en verre de quartz selon l'une quelconque des revendications 1 à 6, le procédé comprenant l'étape consistant à
reformer le creuset en verre de quartz utilisé pour tirer du silicium monocristallin.
